# EUROPEAN PATENT APPLICATION

(11) **EP 4 546 342 A1**
(43) Date of publication of application: **30.04.2025**
(21) Application number: 24795081.9
(22) Date of filing: 03.07.2024
(51) Int. Cl.: G11C 7/22, H03K 3/017

(54) **INFORMATION TRANSMISSION METHOD, MEMORY, CONTROL APPARATUS, AND ELECTRONIC DEVICE**

(30) Priority: 07.09.2023 CN 202311157391
(71) Applicant: CXMT Corporation, Hefei City, Anhui Province 230601 (CN)
(72) Inventor: CHENG, Jingwei, Hefei Anhui 230601 (CN)
(74) Representative: Gulde & Partner
(86) International application number: PCT/CN2024/103421
(87) International publication number: WO 2025/050803

(57) **Abstract**

The present disclosure provides an information transmission method, a memory, a control apparatus, and an electronic device. The method includes: receiving a first target command sent from the outside; and outputting first duty cycle data of an internal data clock signal through a first group of data ports based on the first target command, where the first duty cycle data persists at the first group of data ports at least until a first stop command sent from the outside is received.

## Description

### CROSS-REFERENCE TO RELATED APPLICATIONS

This application is based on Chinese Patent Application No. 202311157391.3 and filed on September 7, 2023, and claims priority to the Chinese Patent Application, which is incorporated herein by reference in its entirety.

### TECHNICAL FIELD

The present disclosure relates to the semiconductor field, and in particular, to an information transmission method, a memory, a control apparatus, and an electronic device.

### BACKGROUND

Taking a dynamic random access memory (DRAM) as an example, a system on chip (SoC) sends a mode register read (MRR) command to the memory, then receives a gating clock signal RDQS(Read Data Strobe) and a data signal DQ (output through a data port) returned by the memory, and performs sampling on the data port of the memory with the gating clock signal RDQS, so as to obtain required data. In addition, the foregoing gating clock signal RDQS is essentially generated according to an external data clock signal WCK0 received by the DRAM from the SoC.

In an initialization phase after power-on, the DRAM needs to first adjust a duty cycle of the external data clock signal WCK0 sent by the SoC, so that a duty cycle of a data clock signal (also referred to as an internal data clock signal WCK1) received by the memory meets a requirement.

### SUMMARY

The present disclosure provides an information transmission method, a memory, a control apparatus, and an electronic device.

The technical solutions of the present disclosure are implemented as follows.

According to a first aspect, an embodiment of the present disclosure provides an information transmission method, applied to a memory. The method includes the steps as follows.

A first target command sent from the outside is received.

First duty cycle data of an internal data clock signal is output through a first group of data ports based on the first target command. The first duty cycle data persists at the first group of data ports at least until a first stop command sent from the outside is received.

In some embodiments, before the first target command sent from the outside is received, the method further includes the steps as follows.

A duty cycle start detection command sent from the outside is received.

One duty cycle detection is performed on the internal data clock signal based on the duty cycle start detection command, to generate the first duty cycle data.

In some embodiments, the method further includes the steps as follows.

The first group of data ports is controlled to be initially in a high-impedance state. The first target command sent from the outside is received. The first duty cycle data is output through the first group of data ports after first preset duration starting from receiving the first target command, and the first duty cycle data persists at the first group of data ports. The first group of data ports is controlled to restore to the high-impedance state after second preset duration starting from receiving the first stop command.

In some embodiments, the method further includes the steps as follows.

Another duty cycle detection is performed on the internal data clock signal based on the first target command to generate second duty cycle data. A second target command sent from the outside is received. The second duty cycle data is output through a second group of data ports based on the second target command, and the second duty cycle data persists at the second group of data ports at least until a second stop command sent from the outside is received.

In some embodiments, the method further includes the steps as follows.

The second group of data ports is controlled to be initially in a high-impedance state. The second target command sent from the outside is received. The second duty cycle data is output through the second group of data ports after third preset duration starting from receiving the second target command, and the second duty cycle data persists at the second group of data ports. The second target command is later than the first target command. The second group of data ports is controlled to restore to the high-impedance state after fourth preset duration starting from receiving the second stop command.

In some embodiments, the first target command is a duty cycle flip detection command; the second target command is a duty cycle flip detection output command; and the first stop command and the second stop command are a same duty cycle detection stop command.

According to a second aspect, an embodiment of the present disclosure provides an information transmission method, applied to a control apparatus. The control apparatus is connected to a memory, and the information transmission method includes the steps as follows.

A first target command is sent to the memory in a duty cycle adjustment mode. Signal sampling is performed on a first group of data ports of the memory with an internal clock signal after the first target command is sent, to obtain first duty cycle data. The internal clock signal is a clock signal generated inside the control apparatus. A first stop command is sent to the memory.

In some embodiments, before the first target command is sent to the memory, the method further includes the step as follows.

A duty cycle start detection command is sent to the memory. The duty cycle start detection command instructs the memory to perform one duty cycle detection on an internal data clock signal to generate the first duty cycle data.

In some embodiments, that signal sampling is performed on a first group of data ports of the memory with an internal clock signal to obtain first duty cycle data includes the step as follows.

The first target command is sent to the memory, and signal sampling is performed on the first group of data ports of the memory with the internal clock signal after fifth preset duration starting from sending the first target command, to obtain the first duty cycle data.

In some embodiments, the first target command further instructs the memory to perform another duty cycle detection on the internal data clock signal to generate second duty cycle data. After the first target command is sent to the memory, the method further includes the step as follows.

A second target command is sent to the memory. Signal sampling is performed on a second group of data ports of the memory with the internal clock signal after the second target command is sent, to obtain the second duty cycle data. A second stop command is sent to the memory.

In some embodiments, that signal sampling is performed on a second group of data ports of the memory with the internal clock signal to obtain the second duty cycle data includes the step as follows.

The second target command is sent to the memory, and signal sampling is performed on the second group of data ports of the memory with the internal clock signal after sixth preset duration starting from sending the second target command, to obtain the second duty cycle data.

In some embodiments, the first target command is a duty cycle flip detection command; the second target command is a duty cycle flip detection output command; and the first stop command and the second stop command are a same duty cycle detection stop command.

In some embodiments, the method further includes the steps as follows. A gating clock signal sent by the memory is received in a non-duty cycle adjustment mode; and signal sampling is performed on a data port of the memory based on the gating clock signal.

According to a third aspect, an embodiment of the present disclosure provides a memory. The memory includes the circuits as follows.

A duty cycle detection circuit is configured to perform one duty cycle detection on an internal data clock signal to generate first duty cycle data. A transmission circuit is connected to both the duty cycle detection circuit and a first group of data ports of the memory, and is configured to: receive a first target command sent from the outside, receive the first duty cycle data based on the first target command, and transmit the first duty cycle data to the first group of data ports. The first duty cycle data persists at the first group of data ports at least until the memory receives a first stop command sent from the outside.

In some embodiments, the duty cycle detection circuit is specifically configured to: receive a duty cycle start detection command sent from the outside; perform one duty cycle detection on the internal data clock signal based on the duty cycle start detection command to generate the first duty cycle data. The first group of data ports is initially in a high-impedance state. The transmission circuit is specifically configured to: receive the first target command sent from the outside, and transmit the first duty cycle data to the first group of data ports after first preset duration starting from receiving the first target command, where the first duty cycle data persists at the first group of data ports; and receive the first stop command sent from the outside, and control the first group of data ports to restore to the high-impedance state after second preset duration starting from receiving the first stop command.

In some embodiments, the duty cycle detection circuit is further configured to: receive the first target command, and perform another duty cycle detection on the internal data clock signal based on the first target command to generate second duty cycle data. The transmission circuit is further configured to: receive a second target command sent from the outside, receive the second duty cycle data based on the second target command, and transmit the second duty cycle data to the second group of data ports. The second duty cycle data persists at the second group of data ports at least until the memory receives a second stop command sent from the outside.

In some embodiments, the second group of data ports is initially in a high-impedance state. The transmission circuit is specifically configured to: receive the second target command sent from the outside, and transmit the second duty cycle data to the second group of data ports after third preset duration starting from receiving the second target command, where the second duty cycle data persists at the second group of data ports, and the second target command is later than the first target command; and receive the second stop command sent from the outside, and control the second group of data ports to restore to the high-impedance state after fourth preset duration starting from receiving the second stop command.

In some embodiments, the duty cycle detection circuit includes a control circuit and a detection circuit. The detection circuit is configured to perform duty cycle detection on a clock signal at a first input terminal of the detection circuit and a clock signal at a second input terminal of the detection circuit. The control circuit is configured to: receive the internal data clock signal and a complementary signal thereof; and output the internal data clock signal to the first input terminal of the detection circuit and output the complementary signal of the internal data clock signal to the second input terminal of the detection circuit based on the received duty cycle start detection command, to enable the detection circuit to output the first duty cycle data; or output the internal data clock signal to the second input terminal of the detection circuit and output the complementary signal of the internal data clock signal to the first input terminal of the detection circuit based on the received first target command, to enable the detection circuit to output the second duty cycle data.

In some embodiments, the first target command is a duty cycle flip detection command; the second target command is a duty cycle flip detection output command; and the first stop command and the second stop command are a same duty cycle detection stop command.

According to a fourth aspect, an embodiment of the present disclosure provides a control apparatus connected to a memory. The control apparatus includes the circuits as follows.

A command generation circuit is configured to: generate a first target command in a duty cycle adjustment mode, and send the first target command to the memory. A clock circuit is configured to generate an internal clock signal. A selection circuit is connected to the clock circuit and the memory, and is configured to: receive a duty cycle detection enable signal, the internal clock signal, and a gating clock signal sent by the memory, and output the internal clock signal as a sample clock signal when the duty cycle detection enable signal represents that the control apparatus is in the duty cycle adjustment mode. A sampling circuit is connected to the selection circuit and a data port of the memory, and is configured to perform signal sampling on a first group of data ports with the sample clock signal after the first target command is sent, to obtain first duty cycle data.

In some embodiments, the sampling circuit is specifically configured to perform signal sampling on the first group of data ports of the memory with the sample clock signal after fifth preset duration starting from sending the first target command, to obtain the first duty cycle data.

In some embodiments, the command generation circuit is further configured to: generate a second target command after sending the first target command, and send the second target command to the memory. The sampling circuit is further configured to perform signal sampling on a second group of data ports of the memory with the internal clock signal after sixth preset duration starting from sending the second target command, to obtain the second duty cycle data.

In some embodiments, the first target command is a duty cycle flip detection command; and the second target command is a duty cycle flip detection output command.

In some embodiments, the selection circuit is further configured to output the gating clock signal as a sample clock signal when the duty cycle detection enable signal represents that the control apparatus is not in the duty cycle adjustment mode.

According to a fifth aspect, an embodiment of the present disclosure provides an electronic device. The electronic device includes at least the memory according to the third aspect and the control apparatus according to the fourth aspect.

Embodiments of the present disclosure provide an information transmission method, a memory, a control apparatus, and an electronic device. A duty cycle detection result (for example, first duty cycle data) of an internal data clock signal is output through a corresponding data port and persists at the corresponding data port, and therefore does not need to be additionally stored in a mode register and read with an MRR command, thereby reducing a quantity of commands and simplifying an interaction process. In addition, because the first duty cycle data persists at the data port for a relatively long period of time, a gating clock signal does not need to be provided, thereby avoiding a problem that the control apparatus cannot sample a detection result due to distortion of the gating clock signal, thereby ensuring correctness of duty cycle detection.

### BRIEF DESCRIPTION OF DRAWINGS

FIG. 1 is a schematic diagram of signal timing for duty cycle detection;
FIG. 2 is a schematic diagram of operation timing of an MRR command;
FIG. 3 is a schematic diagram of a local structure of a memory;
FIG. 4 is a schematic diagram of a waveform of a gating clock signal;
FIG. 5 is a schematic flowchart 1 of an information transmission method according to an embodiment of the present disclosure;
FIG. 6 is a schematic flowchart 2 of an information transmission method according to an embodiment of the present disclosure;
FIG. 7 is a schematic flowchart 3 of an information transmission method according to an embodiment of the present disclosure;
FIG. 8 is a schematic diagram of signal timing for duty cycle detection according to an embodiment of the present disclosure;
FIG. 9 is a schematic diagram 1 of a structure of a memory according to an embodiment of the present disclosure;
FIG. 10 is a schematic diagram 2 of a structure of a memory according to an embodiment of the present disclosure;
FIG. 11 is a schematic diagram of a working scenario of a memory according to an embodiment of the present disclosure;
FIG. 12 is a schematic flowchart 1 of another information transmission method according to an embodiment of the present disclosure;
FIG. 13 is a schematic flowchart 2 of another information transmission method according to an embodiment of the present disclosure;
FIG. 14 is a schematic diagram of a structure of a control apparatus according to an embodiment of the present disclosure; and
FIG. 15 is a schematic diagram of a structure of an electronic device according to an embodiment of the present disclosure.

### DESCRIPTION OF EMBODIMENTS

The technical solutions in the embodiments of the present disclosure are clearly described below with reference to the accompanying drawings in the embodiments of the present disclosure. It may be understood that a specific embodiment described herein is merely intended to explain the related application, but is not intended to limit this application. In addition, it should be further noted that for ease of description, only a part related to the related application is shown in the accompanying drawings.

Unless otherwise defined, all technical and scientific terms utilized in this specification have meanings the same as those commonly understood by a person skilled in the technical field of the present disclosure. The terms utilized in this specification are merely intended to describe the embodiments of the present disclosure, but are not intended to limit the present disclosure.

The following descriptions relate to "some embodiments" describing a subset of all possible embodiments. However, it may be understood that "some embodiments" may be the same subset or different subsets of all the possible embodiments, and may be combined with each other when there is no conflict.

It should be noted that the term "first\second\third" in the embodiments of the present disclosure is merely intended to distinguish between similar objects, and does not represent specific sorting for the objects. It may be understood that "first\second\third" may be interchanged for a specific sequence or order if allowed, so that the embodiments of the present disclosure described herein can be implemented in a sequence other than those shown or described herein.
Dynamic random access memory (DRAM);
synchronous dynamic random access memory (SDRAM);
double data rate SDRAM (DDR);
low power DDR (LPDDR);
Sixth generation LPDDR (LPDDR);
MRR (Mode Register Read): mode register read command;
MRW (Mode Register Write): mode register write command;
Mbps (megabits per second): megabits per second;
NMOS (N-Metal-Oxide-Semiconductor): N-metal-oxide-semiconductor;
PMOS (P-Metal-Oxide-Semiconductor): P-metal-oxide-semiconductor.

A memory (taking LPDDR6 as an example) needs to receive an external data clock signal WCK0 from an SoC to generate an internal data clock signal WCK1, and generate a gating data signal RDQS with the internal data clock signal WCK1. In a working process of a DRAM, a data signal DQ needs to be output on a data port of the DRAM, and a gating data signal RDQS needs to be output synchronously, so that the SoC performs sampling on the data port of the DRAM with the received gating data signal RDQS, so as to obtain required data.

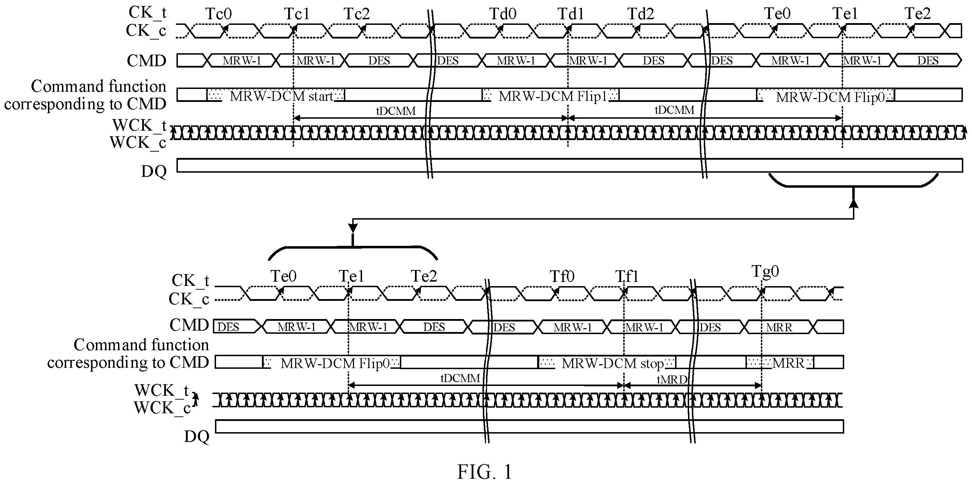

In addition, in an initialization phase of the DRAM, a duty cycle of a received internal data clock signal WCK1 needs to be adjusted, to ensure output quality of subsequent data. After the DRAM adjusts the internal data clock signal WCK1 once, the DRAM further needs to detect a duty cycle of the adjusted internal data clock signal WCK1 and feed back the duty cycle to the SoC, so that the SoC determines whether the duty cycle adjustment is completed. Refer to FIG. 1. FIG. 1 shows a schematic diagram of signal timing for duty cycle detection. In FIG. 1, Tc0, Tc1, and the like are used to identify different clock cycles, CK_c and CK_t are a pair of differential clock signals, CMD indicates an operation command, DQ is an output signal on a data port of a DRAM, and the foregoing internal data clock signal WCK1 may be represented as a single signal or a pair of differential clock signals WCK_c and WCK_t at different circuit locations.

As shown in FIG. 1, a specific process of the duty cycle detection is as follows:
(1) An SoC delivers a duty cycle start detection command (MRW-DCM start) to the DRAM, and the DRAM performs one duty cycle detection on the internal data clock signal WCK1 to obtain first duty cycle data. Herein, the first duty cycle data is not a specific value of a duty cycle of an external data clock signal WCKO, but is a result of comparison between the duty cycle of the external data clock signal WCK0 and 50%.
(2) After a specific time interval (tDCMM), the SoC delivers a duty cycle flip detection command (MRW-DCM Flip 1) to the DRAM, and the DRAM stores the first duty cycle data into a mode register MR. At the same time, the DRAM performs another duty cycle detection on the internal data clock signal WCK1 to obtain second duty cycle data. Herein, the second duty cycle data is also a result of comparison between the duty cycle of the external data clock signal WCK0 and 50%.
(3) After a specific time interval (tDCMM), the SoC delivers a duty cycle flip detection output command (MRW-DCM Flip 0) to the DRAM, and the DRAM stores the second duty cycle data into another mode register MR.
(4) After a specific time interval (tDCMM), the SoC delivers a duty cycle detection stop command (MRW-DCM stop) to the DRAM.
(5) After a specific time interval (tMRD), the SoC delivers a register read command (MRR) to the DRAM, to obtain the first duty cycle data and the second duty cycle data.

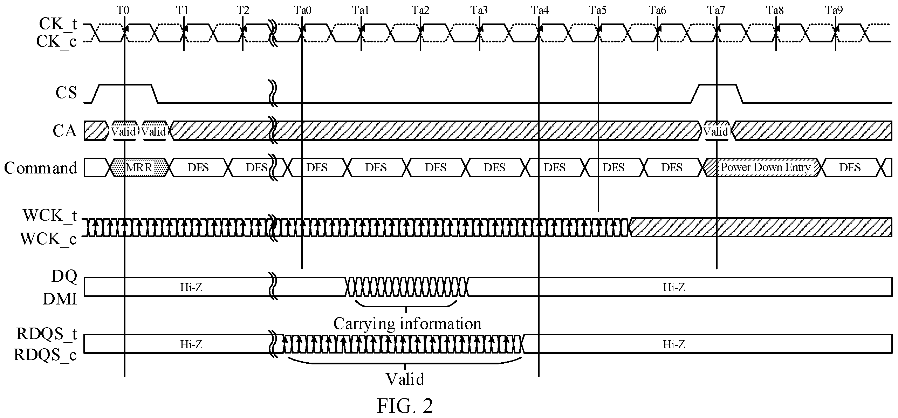

In the DRAM, the MRR command and a normal read command use the same operation timing. Refer to FIG. 2. FIG. 2 shows a schematic diagram of operation timing of an MRR command. In FIG. 2, COMMAND indicates an operation command, and DMI is a data mask inversion signal, and is also output through a data port; the gating clock signal RDQS is a clock signal output by a memory to an electronic device, may be represented as a single signal or a pair of differential clock signals RDQS_c and RDQS_t at different circuit locations, and is essentially generated based on an internal data clock signal WCK1 (WCK_t and WCK_c in FIG. 2).

As shown in FIG. 2, after receiving the MRR command sent by the SoC, the DRAM generates a data signal DQ that carries information on a data port of the DRAM, and generates valid gating clock signals RDQS_c and RDQS_t with the DRAM internal data clock signals WCK_c and WCK_t. In an execution process of the MRR command, the DRAM returns, to the SoC, the data signal DQ that carries information and the valid gating clock signal RDQS together, and then the SoC samples the data signal DQ with the gating clock signal RDQS, to obtain required information. In addition, FIG. 2 shows standard timing specified in the Joint Electron Device Engineering Council (JEDEC) standard. Meanings of signals, principles of related changes, and unmentioned abbreviations of some nouns may be understood by referring to the industry standard document JEDEC, are not related to the technical solutions of the embodiments of the present disclosure, and does not affect an understanding of the embodiments of the present disclosure by a person skilled in the art. Therefore, no explanation is provided.

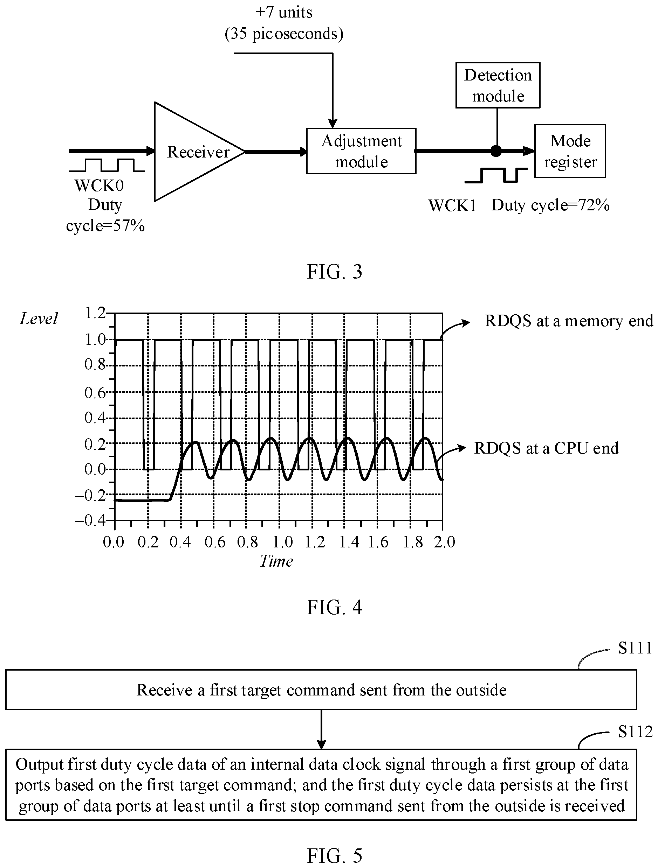

Refer to FIG. 3. FIG. 3 shows a schematic diagram of a local structure of a memory. As shown in FIG. 3, in the memory, a receiver is configured to receive an external data clock signal WCK0 from the outside; an adjustment module adjusts a duty cycle of a received data clock signal (that is, an internal data clock signal WCK1); and a detection module is configured to detect duty cycle parameters (first duty cycle data and second duty cycle data) of the internal data clock signal WCK1, and store the duty cycle parameters in a mode register. In addition, in a process of performing duty cycle adjustment by the memory, the SoC sends an MRR command to read the duty cycle parameters in the mode register, so as to determine a next operation. In an example, as shown in FIG. 3, a duty cycle of an externally input external data clock signal WCK0 is 57% of an upper limit specified in JEDEC. In an initial step of duty cycle adjustment, the adjustment module increases the duty cycle of the external data clock signal WCK0 by 7 units (which is an upper limit specified in JEDEC, where each unit is 5 picoseconds), that is, 35 picoseconds are added, which is equivalent to a 15% increase in a duty cycle at a speed of 8533 Mbps. In this case, the duty cycle of the internal data clock signal WCK1 in the memory is up to 72%, and a duty cycle of a gating clock signal RDQS generated with the internal data clock signal is up to 72%. In this case, refer to FIG. 4. FIG. 4 shows a schematic diagram of a waveform of a gating clock signal. As shown in FIG. 4, a gating clock signal RDQS whose duty cycle is up to 72% is attenuated by a channel in a transmission process through a circuit module, and is severely distorted when arriving at a receive terminal of an SoC, which makes it difficult to be correctly identified by the SoC. That is, the MRR command may obtain incorrect data, which finally causes a duty cycle adjustment failure. If a memory speed is higher, the problem is more serious.

The embodiments of the present disclosure are described below in detail with reference to the accompanying drawings.

In an embodiment of the present disclosure, an information transmission method is provided. The information transmission method may be applied to a memory, such as a DRAM, an SDRAM, a double-rate DRAM, and a low-power double-rate DRAM, and is particularly applicable to LPDDR6.

The information transmission method is specifically applied to a process in which the memory performs duty cycle adjustment on an internal data clock signal WCK1. In short, an SoC generates an external data clock signal WCKO, transmits the external data clock signal WCK0 to the memory, and the memory generates an internal data clock signal WCK1 according to the received external data clock signal WCKO, and performs duty cycle adjustment on the internal data clock signal WCK1. After each duty cycle adjustment is performed, the memory needs to monitor duty cycle information of the internal data clock signal WCK1, and notify the SoC of the duty cycle information, so as to perform a next operation.

Refer to FIG. 5. FIG. 5 shows a schematic flowchart 1 of an information transmission method according to an embodiment of the present disclosure. As shown in FIG. 5, the method includes the steps as follows.

In step S111, a first target command sent from the outside is received.

It should be noted that "the outside" may be an SoC. For example, the first target command may be a duty cycle start detection command MRW-DCM start, a duty cycle flip detection command MRW-DCM Flip 1, or an additionally defined new command.

In step S112, first duty cycle data of an internal data clock signal is output through a first group of data ports based on the first target command. The first duty cycle data persists at the first group of data ports at least until a first stop command sent from the outside is received.

It should be noted that the first duty cycle data indicates duty cycle information of the internal data clock signal, and is specifically a result of comparison between the internal data clock signal and 50%. The first stop command may have multiple possibilities, for example, a duty cycle flip detection output command MRW-DCM Flip0, a duty cycle detection stop command MRW-DCM stop, a (next) duty cycle adjustment command, a (next) duty cycle start detection command MRW-DCM start, a (next) duty cycle flip detection command MRW-DCM Flip 1, or an additionally introduced new command.

Herein, the memory includes multiple data ports, configured to transmit data signals DQ. The first group of data ports are one or more data ports of the memory. In addition, a quantity of data ports included in the first group of data ports is the same as a quantity of bits of the first duty cycle data.

In this way, in this embodiment of the present disclosure, there is no need to wait for the SoC to deliver a dedicated MRR command. After receiving the first target command, the memory directly transmits the first duty cycle data obtained through detection to the first group of data ports, and the first duty cycle data persists at the first group of data ports for a specific time period. Therefore, the SoC can obtain the correct first duty cycle data by sampling the first group of data ports at any time point in the time period, thereby avoiding a duty cycle adjustment failure, reducing a quantity of interaction commands, and saving power consumption.

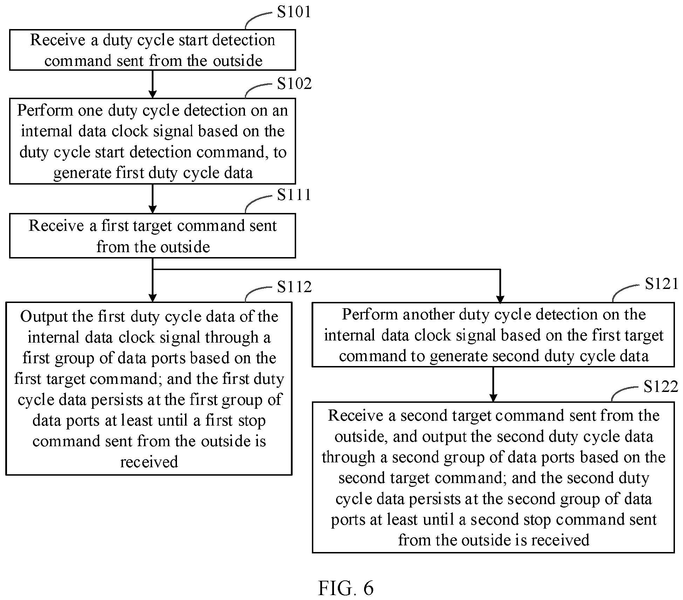

In some embodiments, as shown in FIG. 6, the method further includes steps S101 and S102 before step S111.

In step S101, a duty cycle start detection command sent from the outside is received.

In step S102, one duty cycle detection is performed on the internal data clock signal based on the duty cycle start detection command, to generate the first duty cycle data.

Herein, the duty cycle start detection command MRW-DCM start is a command that is delivered by the SoC to the memory and used to instruct the memory to detect a duty cycle of the internal data clock signal.

In some embodiments, the method further includes steps S121 and S122 after step S111.

In step S121, another duty cycle detection is performed on the internal data clock signal based on the first target command to generate second duty cycle data.

That is, the first target command has two functions: (1) instructing the memory to output the first duty cycle data; (2) instructing the memory to flip the internal data clock signal and perform another duty cycle detection, so as to balance a mismatch problem of a measurement circuit. For details, refer to subsequent description.

In step S122, a second target command sent from the outside is received; and the second duty cycle data is output through a second group of data ports based on the second target command, and the second duty cycle data persists at the second group of data ports at least until a second stop command sent from the outside is received.

It should be noted that the second target command may be the foregoing duty cycle flip detection output command MRW-DCM Flip0 or an additionally defined new command.

The second stop command also has multiple possibilities, for example, a duty cycle detection stop command MRW-DCM stop, a (next) duty cycle adjustment command, a (next) duty cycle start detection command MRW-DCM start, a (next) duty cycle flip detection command MRW-DCM Flip1, a (next) duty cycle flip detection output command MRW-DCM Flip0, or an additionally introduced new command.

Herein, the second group of data ports are also one or more data ports of the memory, and there is no duplicate data port in the second group of data ports and the first group of data ports. In addition, a quantity of data ports included in the second group of data ports is the same as a quantity of bits of the second duty cycle data.

In this way, in this embodiment of the present disclosure, there is no need to wait for the SoC to deliver a dedicated MRR command. After receiving the second target command, the memory directly transmits the second duty cycle data obtained through detection to the second group of data ports, and the second duty cycle data persists at the second group of data ports for a specific time period. Therefore, the SoC can obtain the correct second duty cycle data by sampling the second group of data ports at any time point in the time period, thereby avoiding a duty cycle failure.

In some embodiments, the method further includes the step as follows.

An external data clock signal WCK0 sent from the outside (SoC) is received; and an internal data clock signal WCK1 is generated based on the external data clock signal WCK0.

In a specific scenario, only one internal data clock signal WCK1 (which may be represented as a single signal or a pair of differential signals WCK_t and WCK_c at different circuit locations) exists in the memory, and all data signals DQ share the internal data clock signal WCK1. In this case, the external data clock signal WCK0 sent by the SoC is also a signal that may be specifically a single-terminal signal or a pair of differential signals.

Correspondingly, the memory further includes a detection circuit. The detection circuit has a first input terminal (S1) and a second input terminal (S2), the first input terminal (S1) and the second input terminal (S2) each receive one clock signal, and the clock signal of the first input terminal (S1) and the clock signal of the second input terminal (S2) are complementary. The detection circuit may include components such as a comparator, an NMOS, and a PMOS. Detailed functions of the detection circuit may slightly vary depending on a connection relationship of the components. For example, the detection circuit can detect whether a duty cycle of a clock signal at the first input terminal (S1) is greater than a duty cycle of a clock signal at the second input terminal (S2). For example, if the duty cycle of the clock signal at the first input terminal is greater than the duty cycle of the clock signal at the second input terminal, the detection circuit outputs a high-level signal. Because the clock signal at the first input terminal and the clock signal at the second input terminal are complementary, it also represents that the duty cycle of the clock signal at the first input terminal is greater than 50%. Similarly, if the duty cycle of the clock signal at the first input terminal is less than the duty cycle of the clock signal at the second input terminal, a low-level signal is output. Because the clock signal at the first input terminal and the clock signal at the second input terminal are complementary, it also represents that a duty cycle of a low-bit data clock signal is less than 50%.

Therefore, step S102 is specifically as follows.

The internal data clock signal is transmitted to the first input terminal (S1) of the detection circuit, and a complementary signal of the internal data clock signal is transmitted to the second input terminal (S2) of the detection circuit, to obtain the first duty cycle data from an output terminal of the detection circuit.

Step S121 is specifically as follows.

The internal data clock signal is transmitted to the second input terminal (S2) of the detection circuit, and the complementary signal of the internal data clock signal is transmitted to the first input terminal (S1) of the detection circuit, to obtain the second duty cycle data from the output terminal of the detection circuit.

In this way, the mismatch and error problems on a line of the detection circuit may be offset by performing two times of duty cycle detection in which the signals are swapped at the input terminals, so that a result of duty cycle detection is more accurate.

In a specific embodiment, the detection circuit has one output terminal (Q). In this case, ideally, the first duty cycle data and the second duty cycle data are complementary. However, because of a mismatch of a first detection circuit/a second detection circuit, the first duty cycle data and the second duty cycle data may not be completely complementary.

In another specific embodiment, the detection circuit has two output terminals: a non-inverting output terminal (Q) and an inverting output terminal (Q/). In this case, the first duty cycle data is output from the non-inverting output terminal (Q), and the second duty cycle data is output from the inverting output terminal (Q/). In this case, ideally, the first duty cycle data and the second duty cycle data are the same. However, a mismatch of the detection circuit itself may cause a fact that the first duty cycle data and the second duty cycle data are not completely the same.

In addition, in this scenario, the first duty cycle data and the second duty cycle data each include only one bit of data. For example, if the first duty cycle data = 1, it indicates that a duty cycle of the internal data clock signal WCK_t is greater than 50%; if the first duty cycle data = 0, it indicates that the duty cycle of the internal data clock signal WCK_t is less than 50%. If the second duty cycle data = 1, it indicates that a duty cycle of the complementary signal WCK_c of the internal data clock signal is less than 50%; if the second duty cycle data = 0, it indicates that the duty cycle of the complementary signal WCK_c of the internal data clock signal is greater than 50%. Certainly, the foregoing is only an example, and value meanings of the first duty cycle data and the second duty cycle data may be limited according to an actual application scenario. Correspondingly, the first group of data ports includes one data port, and the second group of data ports includes another data port.

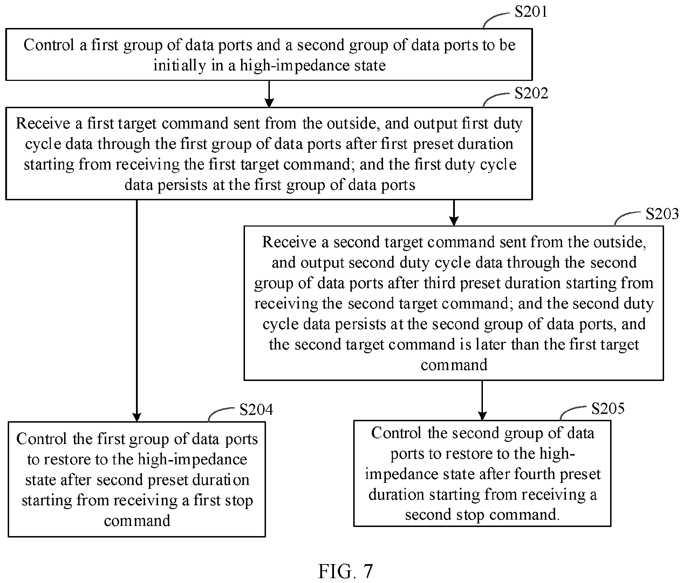

In a specific example, the following describes a working process of the first group of data ports and the second group of data ports with reference to FIG. 7.

In step S201, the first group of data ports and the second group of data ports are controlled to be initially in a high-impedance state.

In step S202, a first target command sent from the outside is received; and first duty cycle data is output through the first group of data ports after first preset duration starting from receiving the first target command, and the first duty cycle data persists at the first group of data ports.

In step S203, a second target command sent from the outside is received; second duty cycle data is output through the second group of data ports after third preset duration starting from receiving the second target command, and the second duty cycle data persists at the second group of data ports; and the second target command is later than the first target command.

In step S204, the first group of data ports is controlled to restore to the high-impedance state after second preset duration starting from receiving the first stop command.

In step S205, the second group of data ports is controlled to restore to the high-impedance state after fourth preset duration starting from receiving the second stop command.

Herein, the first preset duration and the third preset duration may be the same or different, the second preset duration and the fourth preset duration may be the same or different, the first preset duration and the second preset duration may be the same or different, and the third preset duration and the fourth preset duration may be the same or different. An execution sequence of the foregoing steps is merely an example. In an actual scenario, different steps are not necessarily performed according to the foregoing sequence, and may overlap or be executed simultaneously.

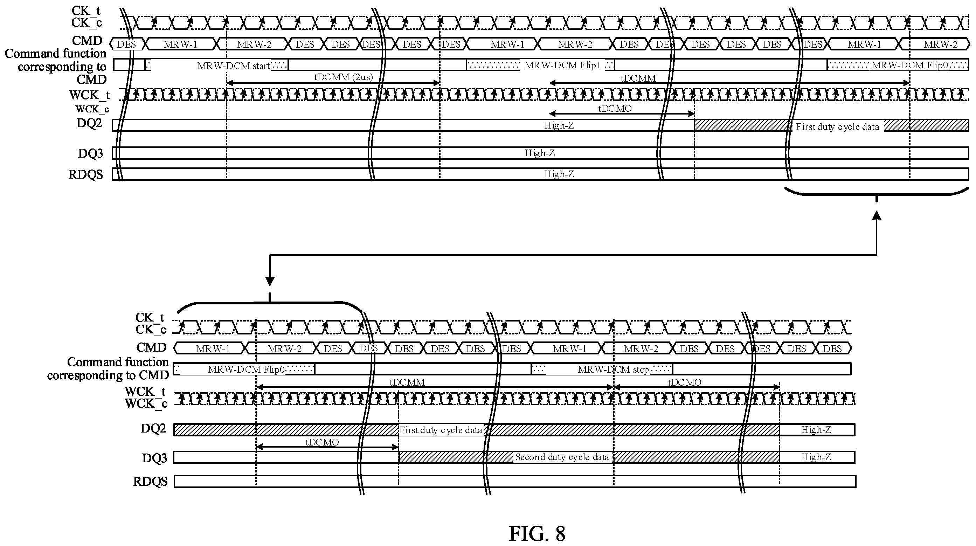

In a specific embodiment, the first target command is a duty cycle flip detection command MRW-DCM Flip 1. The second target command is a duty cycle flip detection output command MRW-DCM Flip 0. The first stop command and the second stop command are a same duty cycle detection stop command MRW-DCM stop. The first preset duration, the second preset duration, the third preset duration, and the fourth preset duration are the same, and are represented as tDCMO. The first group of data ports is represented as DQ2, and the second group of data ports is represented as DQ3. Refer to FIG. 8. FIG. 8 shows a schematic diagram of signal timing according to an embodiment of the present disclosure. As shown in FIG. 8:
(1) Initial states of both DQ2 and DQ3 are high-impedance states High-Z, that is, no valid signal is transmitted on DQ2 and DQ3.
(2) After the memory receives MRW-DCM start, duty cycle detection is performed on the internal data clock signal WCK1. It is assumed that obtained first duty cycle data is 1.
(3) After the memory receives MRW-DCM Flip1, and after a period of tDCMO (for example, 2 us) elapses after the memory receives MRW-DCM Flip 1, DQ2 continuously outputs high-level signals (that is, the first duty cycle data). At the same time, MRW-DCM Flip1 further instructs to perform duty cycle detection on WCK1 again. It is assumed that obtained second duty cycle data is also 1.
(4) After the memory receives MRW-DCM Flip0, and after a period of tDCMO (for example, 2 us) elapses after the memory receives MRW-DCM Flip0, DQ3 outputs high-level signals (that is, the second duty cycle data).
(5) DQ2 and DQ3 restore to the high-impedance state High-Z after tDCMO elapses after the memory receives a duty cycle detection stop command (MRW-DCM stop), so as to complete one measurement and output of duty cycle data.

For ease of description, a moment at which the MRW-DCM Flip 1 command is received is denoted as TA, a moment at which the MRW-DCM Flip0 command is received is denoted as TB, and a moment at which the MRW-DCM stop command is received is denoted as TC. In this case, in a time period of (TA+tDCMO) to (TC+tDCMO), DQ2 continuously outputs the first duty cycle data; and in a time period of (TB+tDCMO) to (TC+tDCMO), DQ3 continuously outputs the second duty cycle data. In this way, because the first duty cycle data and the second duty cycle data are respectively continuously output for a long time, the SoC may perform sampling with an internal clock signal of the SoC. Therefore, the memory does not need to output the RDQS, that is, an RDQS port clock is in a high-impedance state High-Z.

In addition, specific locations of the first group of data ports and the second group of data ports are not limited. For an 8-bit memory, the first group of data ports and the second group of data ports may be any two data ports in DQ0 to DQ7. For a 16-bit memory, the first group of data ports and the second group of data ports may be any two data ports in DQ0 to DQ15. This is not limited to DQ2 to DQ5 in the foregoing scenario.

In some embodiments, the method further includes the steps as follows.

A duty cycle adjustment command sent from the outside is received, and the duty cycle of the internal data clock signal is adjusted based on the duty cycle adjustment command.

A duty cycle start detection command, a duty cycle flip detection command, a duty cycle flip detection output command, and a duty cycle detection stop command are successively received.

A next duty cycle adjustment command, a next duty cycle start detection command, a next duty cycle flip detection command, a next duty cycle flip detection output command, and a next duty cycle detection stop command that are sent from the outside continue to be received until the duty cycle adjustment of the internal data clock signal is completed. Herein, the duty cycle adjustment command is a command that is delivered by the SoC and instructs the memory to adjust a duty cycle of a low-bit data clock signal and/or a high-bit data clock signal.

It should be noted that the SoC determines, according to multiple consecutive pieces of first duty cycle data, whether adjustment of the duty cycle of the low-bit data clock signal by the memory is completed, and after the adjustment is completed, the SoC does not deliver a corresponding duty cycle adjustment command. Similarly, the SoC determines, according to multiple consecutive pieces of received second duty cycle data, whether adjustment of the duty cycle of the high-bit data clock signal is completed, and after the adjustment is completed, the SoC does not deliver a corresponding duty cycle adjustment command.

In another specific scenario, a high-speed memory synchronously outputs data signals DQ having a large quantity of bits, which may generally be classified into a high-bit data signal DQH and a low-bit data signal DQL. Correspondingly, the internal data clock signal WCK1 includes two independent clock signals, that is, a low-bit data clock signal LWCK (which may be represented as a single signal or a pair of differential signals LWCK_t and LWCK_c at different circuit locations) and a high-bit data clock signal (which may be represented as a single signal or a pair of differential signals HWCK_t and HWCK_c at different circuit locations). All low-bit data signals share the low-bit data clock signal LWCK, and all high-bit data signals share the high-bit data clock signal HWCK.

For example, a 16-bit memory may synchronously output 16-bit data signals DQ[15:0]. DQ[7:0] are all low-bit data signals, and need to be generated according to a low-bit data clock signal LWCK. DQ[15:8] are all high-bit data signals, and need to be generated according to a high-bit data clock signal HWCK.

Correspondingly, the method further includes the steps as follows.

A low-bit external data clock signal (which may be specifically a single-terminal signal or a pair of differential signals) and a high-bit external data clock signal (which may be specifically a single-terminal signal or a pair of differential signals) that are sent from the outside (SoC) are received; a low-bit data clock signal LWCK is generated based on the low-bit external data clock signal; and a high-bit data clock signal HWCK is generated based on the high-bit external data clock signal.

In this case, the first duty cycle data includes a first low-bit duty cycle value and a first high-bit duty cycle value. The first low-bit duty cycle value is used to indicate a duty cycle of the low-bit data clock signal, and the first high-bit duty cycle value is used to indicate a duty cycle of the high-bit data clock signal.

The memory further includes a first detection circuit and a second detection circuit, and the foregoing step S102 may specifically include the steps as follows.

A low-bit data clock signal (for example, LWCK_t) is transmitted to a first input terminal (S1) of the first detection circuit, a complementary signal (for example, LWCK_c) of the low-bit data clock signal is transmitted to a second input terminal (S2) of the first detection circuit, and a first low-bit duty cycle value is obtained from an output terminal of the first detection circuit. A high-bit data clock signal (for example, HWCK_t) is transmitted to a first input terminal (S1) of the second detection circuit, a complementary signal (for example, HWCK_c) of the high-bit data clock signal is transmitted to a second input terminal (S2) of the second detection circuit, and a first high-bit duty cycle value is obtained from an output terminal of the second detection circuit.

It should be noted that the first detection circuit, the second detection circuit, and the foregoing detection circuit have a same principle.

In addition, because the first duty cycle data and the second duty cycle data each include a two-bit signal, the first group of data ports and the second group of data ports each need to include two data ports.

In conclusion, this embodiment of the present disclosure provides a signal transmission method applied to a memory. After duty cycle detection is performed on the internal data clock signal, a detection result is output through a corresponding data port based on a subsequently received first target command, and persists at the corresponding data port, and the detection result does not need to be additionally stored in a mode register and then read with an MRR command, thereby reducing a quantity of commands and simplifying an interaction process. In addition, because the detection result persists at the data port for a relatively long period of time, a gating clock signal does not need to be provided, thereby avoiding a problem that the control apparatus cannot sample the detection result due to distortion of the gating clock signal, thereby ensuring correctness of duty cycle detection.

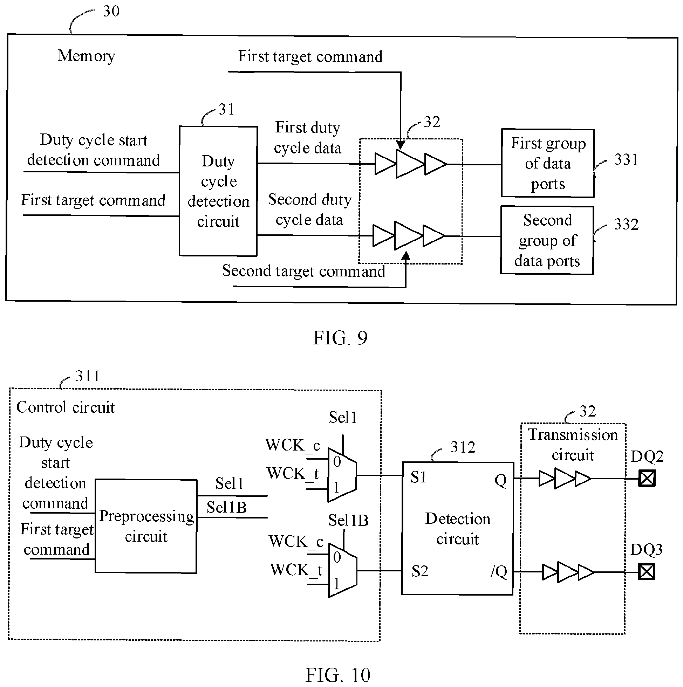

In another embodiment of the present disclosure, to implement the foregoing signal transmission method, refer to FIG. 9. FIG. 9 shows a schematic diagram of a structure of a memory 30 according to an embodiment of the present disclosure. As shown in FIG. 9, the memory 30 includes the following circuits.

A duty cycle detection circuit 31 is configured to perform one duty cycle detection on an internal data clock signal WCK1, to generate first duty cycle data.

A transmission circuit 32 is connected to both the duty cycle detection circuit 31 and a first group of data ports 331 of the memory 30, and is configured to: receive a first target command sent from the outside, receive first duty cycle data based on the first target command, and transmit the first duty cycle data to the first group of data ports 331. The first duty cycle data persists at the first group of data ports 331 at least until the memory 30 receives a first stop command sent from the outside.

It should be noted that in FIG. 9, the transmission circuit 32 is merely a simple example. In fact, the transmission circuit 32 may include multiple circuit components such as a signal selector, a driver, and a three-state output gate, or may combine some lines in a multiplexing manner to simplify a circuit structure.

In some embodiments, the duty cycle detection circuit 31 is specifically configured to receive a duty cycle start detection command sent from the outside, and perform one duty cycle detection on the internal data clock signal WCK1 based on the duty cycle start detection command, to generate the first duty cycle data.

In some embodiments, the first group of data ports 331 is initially in a high-impedance state.

The transmission circuit 32 is specifically configured to: receive a first target command sent from the outside, and transmit the first duty cycle data to the first group of data ports 331 after first preset duration starting from receiving the first target command, where the first duty cycle data persists at the first group of data ports; and receive the first stop command sent from the outside, and control the first group of data ports 331 to restore to the high-impedance state after second preset duration starting from receiving the first stop command. In some embodiments, as shown in FIG. 9, the duty cycle detection circuit 31 is further configured to: receive the first target command, and perform another duty cycle detection on the internal data clock signal based on the first target command, to generate second duty cycle data.

The transmission circuit 32 is further configured to: receive a second target command sent from the outside, receive the second duty cycle data based on the second target command, and transmit the second duty cycle data to a second group of data ports 332. The second duty cycle data persists at the second group of data ports 332 at least until the memory 30 receives a second stop command sent from the outside.

Specifically, the second group of data ports 332 is initially in a high-impedance state.

The transmission circuit 32 is specifically configured to: receive the second target command sent from the outside, and transmit the second duty cycle data to the second group of data ports 332 after third preset duration starting from receiving the second target command, where the second duty cycle data persists at the second group of data ports, and the second target command is later than the first target command; and receive the second stop command sent from the outside, and control the second group of data ports 332 to restore to the high-impedance state after fourth preset duration starting from receiving the second stop command.

In some embodiments, the memory 30 further includes a clock processing circuit configured to: receive an external data clock signal WCK0 sent from the outside, and generate an internal data clock signal WCK1 based on the external data clock signal WCK0.

In a specific possibility, only one internal data clock signal WCK1 (which may be represented as a single signal or a pair of differential signals WCK_t and WCK_c at different circuit locations) exists in the memory, and all data signals DQ share the internal data clock signal WCK1. In this case, the external data clock signal WCK0 sent by the SoC is also a signal that may be specifically a single-terminal signal or a pair of differential signals.

In this case, as shown in FIG. 10, the duty cycle detection circuit 31 includes a control circuit 311 and a detection circuit 312.

The detection circuit 312 is configured to perform duty cycle detection on a clock signal at a first input terminal of the detection circuit and a clock signal at a second input terminal of the detection circuit.

The control circuit 311 is configured to: receive an internal data clock signal and a complementary signal thereof; output the internal data clock signal WCK_t to the first input terminal (S1) of the detection circuit 312 and output the complementary signal WCK_c of the internal data clock signal to the second input terminal (S2) of the detection circuit 312 based on a received duty cycle start detection command, so that the detection circuit 312 outputs first duty cycle data; or
output the internal data clock signal WCK_t to the second input terminal (S2) of the detection circuit 312 and output the complementary signal WCK_c of the internal data clock signal to the first input terminal (S1) of the detection circuit 312 based on a received first target command, so that the detection circuit 312 outputs second duty cycle data.

For example, the control circuit 311 specifically includes a preprocessing circuit and two either-or data selectors. The preprocessing circuit outputs four selection signals Sel1 and Sel1B according to whether a duty cycle start detection command is received and whether a duty cycle flip detection command is received, and the levels of Sel1 and Sel1B are complementary. For the first data selector, two input terminals of the first data selector respectively receive WCK_c and WCK_t, a selection terminal receives Sel1, and an output terminal is connected to the first input terminal (S1) of the detection circuit 312. For the second data selector, two input terminals of the second data selector respectively receive WCK_c and WCK_t, a selection terminal receives Sel1B, and an output terminal is connected to the second input terminal (S2) of the detection circuit 312.

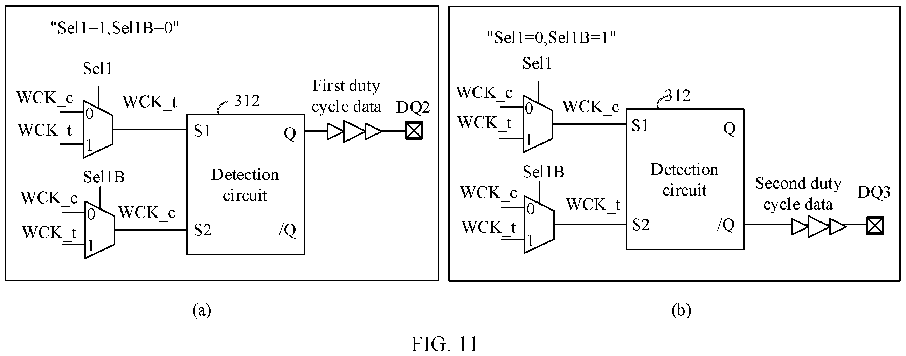

Refer to (a) in FIG. 11. After the SoC delivers the duty cycle start detection command, Sel1=1, and Sel1B=0. For the detection circuit 312, the first input terminal (S1) receives WCK_t, the second input terminal (S2) receives WCK_c, and a non-inverting output terminal (Q) outputs first duty cycle data to the data port DQ2.

Refer to (b) in FIG. 11. After the SoC delivers the first target command, Sel1=0, and Sel1B=1. For the detection circuit 312, the first input terminal (S1) receives WCK_c, the second input terminal (S2) receives WCK_t, and an inverting output terminal (/Q) outputs second duty cycle data to the data port DQ3.

In a specific embodiment, the first target command is a duty cycle flip detection command; the second target command is a duty cycle flip detection output command; and the first stop command and the second stop command are a same duty cycle detection stop command.

In another working scenario, the internal data clock signal WCK1 includes a low-bit data clock signal LWCK and a high-bit data clock signal HWCK. That is, the memory 30 receives the external data clock signal WCK0 from the SoC, and further generates the low-bit data clock signal LWCK and the high-bit data clock signal HWCK.

Correspondingly, the first duty cycle data includes a first low-bit duty cycle value and a first high-bit duty cycle value, and the second duty cycle data includes a second low-bit duty cycle value and a second high-bit duty cycle value.

Correspondingly, the duty cycle detection circuit 31 includes a control circuit 311, a first detection circuit, and a second detection circuit. Functions of the first detection circuit and the second detection circuit are the same. That is, the first detection circuit is configured to perform duty cycle detection on a clock signal at a first input terminal of the first detection circuit and a clock signal at a second input terminal of the first detection circuit, and the second detection circuit is configured to perform duty cycle detection on a clock signal at a first input terminal of the second detection circuit and a clock signal at a second input terminal of the second detection circuit.

The control circuit 311 is configured to: receive a low-bit data clock signal and a complementary signal of the low-bit data clock signal (refer to LWCK_c/LWCK_t in FIG. 10), and a high-bit data clock signal and a complementary signal of the high-bit data clock signal (refer to HWCK_c/HWCK_t in FIG. 10); and based on a received duty cycle start detection command, output the low-bit data clock signal LWCK_t to a first input terminal (S1) of the first detection circuit and output the complementary signal LWCK_c of the low-bit data clock signal to a second input terminal (S2) of the first detection circuit, so that the first detection circuit outputs a first low-bit duty cycle value; and output the high-bit data clock signal HWCK_t to a first input terminal (S1) of the second detection circuit and output the complementary signal HWCK_c of the high-bit data clock signal to a second input terminal (S2) of the second detection circuit, so that the second detection circuit outputs a first high-bit duty cycle value.

The control circuit 311 is further configured to: based on a received duty cycle flip detection command, output the low-bit data clock signal LWCK_t to the second input terminal (S2) of the first detection circuit and output the complementary signal LWCK_c of the low-bit data clock signal to the first input terminal (S1) of the first detection circuit, so that the first detection circuit outputs a second low-bit duty cycle value; and output the high-bit data clock signal HWCK_t to the second input terminal (S2) of the second detection circuit and output the complementary signal HWCK_c of the high-bit data clock signal to the first input terminal (S1) of the second detection circuit, so that the second detection circuit outputs a second high-bit duty cycle value.

In conclusion, this embodiment of the present disclosure provides a memory. After duty cycle detection is performed on the internal data clock signal, a detection result is output through a corresponding data port based on a subsequently received first target command, and persists at the corresponding data port, and the detection result does not need to be additionally stored in a mode register and then read with an MRR command, thereby reducing a quantity of commands and simplifying an interaction process. In addition, because the detection result persists at the data port for a relatively long period of time, a gating clock signal does not need to be provided, thereby avoiding a problem that the control apparatus cannot sample the detection result due to distortion of the gating clock signal, thereby ensuring correctness of duty cycle detection.

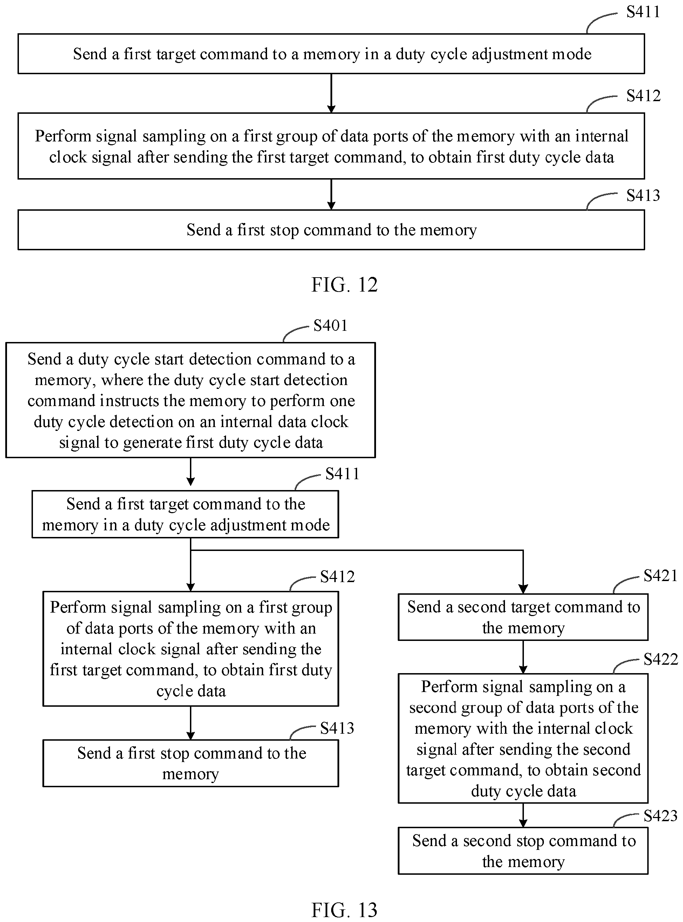

In still another embodiment, refer to FIG. 12. FIG. 12 shows a schematic flowchart 1 of another information transmission method according to an embodiment of the present disclosure. The information transmission method may be applied to a control apparatus (which may be referred to as an SoC), and the control apparatus is connected to the foregoing memory.

The information transmission method is specifically applied to a process in which the memory performs duty cycle adjustment on an internal data clock signal. In short, the SoC generates an external data clock signal WCKO, transmits the external data clock signal WCK0 to the memory, and the memory generates an internal data clock signal WCK1 according to the received external data clock signal WCKO, and performs duty cycle adjustment on the internal data clock signal WCK1. After the memory performs duty cycle adjustment each time, the SoC needs to learn duty cycle information of the adjusted internal data clock signal WCK1 in the memory.

As shown in FIG. 12, the information transmission method includes the following steps.

In step S411, a first target command is sent to the memory in a duty cycle adjustment mode.

It should be noted that, for step S401, "in a duty cycle adjustment mode" may be considered as a usage scenario rather than a limitation feature. That is, when the SoC internally generates a duty cycle start detection command and sends the duty cycle start detection command to the memory, it may be considered that the SoC is in the duty cycle adjustment mode, and the SoC does not need to enter the duty cycle adjustment mode with a physical behavior, and then send the duty cycle start detection command to the memory.

In step S412, signal sampling is performed on a first group of data ports of the memory with an internal clock signal after the first target command is sent, to obtain first duty cycle data.

It should be noted that the internal clock signal is a clock signal generated by the control apparatus internally through an oscillator or a similar module, and is subsequently represented as CLKIn.

In step S413, a first stop command is sent to the memory.

In some embodiments, as shown in FIG. 13, the method further includes step S401 before step S411.

In step S401, a duty cycle start detection command is sent to the memory. The duty cycle start detection command instructs the memory to perform one duty cycle detection on an internal data clock signal to generate the first duty cycle data.

In this way, as described above, the memory transmits the first duty cycle data on the first group of data ports for a period of time after the SoC delivers the duty cycle start detection command to the memory. Correspondingly, the SoC may perform sampling on the first group of data ports of the memory with the internal clock signal CLKIn of the SoC, to obtain correct first duty cycle data.

In some embodiments, the first target command further instructs the memory to perform another duty cycle detection on the internal data clock signal to generate second duty cycle data. Correspondingly, as shown in FIG. 13, the method further includes steps S421 to S423 after step S412.

In step S421, a second target command is sent to the memory.

In step S422, signal sampling is performed on a second group of data ports of the memory with the internal clock signal after the second target command is sent, to obtain second duty cycle data.

In step S423, a second stop command is sent to the memory.

In some embodiments, step S412 specifically includes: sending the first target command to the memory, and performing signal sampling on the first group of data ports of the memory with the internal clock signal after fifth preset duration starting from sending the first target command, to obtain the first duty cycle data.

Similarly, step S422 specifically includes: sending the second target command to the memory, and performing signal sampling on the second group of data ports of the memory with the internal clock signal after sixth preset duration starting from sending the second target command, to obtain the second duty cycle data.

It should be noted that the fifth preset duration is at least greater than first preset duration, and the sixth preset duration is at least greater than third preset duration.

In a specific embodiment, the first target command is a duty cycle flip detection command; the second target command is a duty cycle flip detection output command; and the first stop command and the second stop command are a same duty cycle detection stop command.

Specifically, if the first stop command and the second stop command are a same duty cycle detection stop command, the method further includes: sending the duty cycle detection stop command to the memory, so as to implement simultaneous transmission of the first stop command and the second stop command to the memory. That is, step S413 and step S423 are simultaneously completed with one action.

In other words, the SoC only needs to send one duty cycle detection stop command to the memory, and it may be considered that the SoC delivers the first stop command and delivers the second stop command.

In some embodiments, the method further includes the step as follows.

An external data clock signal WCK0 is sent to the memory, so that the memory generates an internal data clock signal WCK1 based on the external data clock signal WCK0.

The first duty cycle data indicates a result of one duty cycle detection performed on the internal data clock signal by the memory, and the second duty cycle data indicates a result of another duty cycle detection performed on the internal data clock signal by the memory.

In a scenario, only one internal data clock signal WCK1 (which may be represented as a single signal or a pair of differential signals WCK_t and WCK_c at different circuit locations) exists in the memory, and all data signals DQ share the internal data clock signal WCK1. In this case, the first duty cycle data and the second duty cycle data each include a 1-bit signal, and the first group of data ports and the second group of data ports each include one data port.

In another scenario, a high-speed memory synchronously outputs data signals DQ having a large quantity of bits, which may generally be classified into a high-bit data signal DQH and a low-bit data signal DQL. Correspondingly, the internal data clock signal WCK1 includes two independent clock signals, that is, a low-bit data clock signal LWCK (which may be represented as a single signal or a pair of differential signals LWCK_t and LWCK_c at different circuit locations) and a high-bit data clock signal (which may be represented as a single signal or a pair of differential signals HWCK_t and HWCK_c at different circuit locations). All low-bit data signals share the low-bit data clock signal LWCK, and all high-bit data signals share the high-bit data clock signal HWCK. In this case, the first duty cycle data and the second duty cycle data each include a 2-bit signal, and the first group of data ports and the second group of data ports each include two data ports.

In some embodiments, the method further includes the steps as follows.

Whether the memory completes duty cycle adjustment on the internal data clock signal is determined based on the first duty cycle data and the second duty cycle data.

When the duty cycle adjustment on the internal data clock signal is not completed, a duty cycle adjustment command is sent to the memory, to instruct the memory to continue to adjust the duty cycle of the internal data clock signal.

A next duty cycle start detection command, a next duty cycle flip detection command, a next duty cycle flip detection output command, and a next duty cycle detection stop command are sent to the memory.

For example, a duty cycle adjustment process is as follows. When the SoC delivers a duty cycle adjustment command to the memory, the memory increases/decreases a duty cycle adjustment code (the increase or decrease may be carried in the duty cycle adjustment command, or is not carried in the duty cycle adjustment command but designed by the memory in advance), so that the duty cycle of the WCK increases or decreases by a preset step. After the duty cycle adjustment code is adjusted each time, the SoC continues to deliver a duty cycle start detection command, a duty cycle flip detection command, a duty cycle flip detection output command, and a duty cycle detection stop command, so as to complete an adjustment cycle.

As shown in Table 1, Table 1 provides an example adjustment scenario. Specifically, when the duty cycle adjustment code=-1, the first duty cycle data is flipped, and when the duty cycle adjustment code=+3, the second duty cycle data is flipped. In this case, it may be considered that +1 (an intermediate value of -1 to +3) of the duty cycle adjustment code is a final value. In this case, after the duty cycle adjustment ends, the SoC further notifies the memory of the final value of the duty cycle adjustment code, so that the memory locks the duty cycle adjustment code to +1.

In the foregoing scenario, when the duty cycle adjustment code changes to an adjustment cycle corresponding to +3, it may be considered that adjustment of the low-bit data clock signal LWCK ends.

**Table 1**

| | | | |
|---|---|---|---|
| Adjustment code (DCA Code) | First duty cycle data | Second duty cycle data | Meaning of duty cycle value: |
| | | | 0: <50%; |
| -7 | 0 | 0 | 1: >50% |
| -6 | 0 | 0 | |
| -5 | 0 | 0 | |
| -4 | 0 | 0 | |
| -3 | 0 | 0 | |
| -2 | 0 | 0 | |
| -1 | 1 | 0 | |
| 0 | 1 | 0 | |
| +1 | 1 | 0 | |
| +2 | 1 | 0 | |
| +3 | 1 | 1 | |
| +4 | 1 | 1 | |
| +5 | 1 | 1 | |
| +6 | 1 | 1 | |
| +7 | 1 | 1 | |

In some embodiments, the method further includes the steps as follows.

A gating clock signal RDQS sent by the memory is received in a non-duty cycle adjustment mode, and signal sampling is performed on a data port of the memory based on the gating clock signal RDQS.

It should be understood that in a normal working process after the duty cycle adjustment ends, the memory needs to provide a gating clock signal RDQS while transmitting a data signal (transmission speed is relatively fast) through a data port of the memory. The SoC needs to perform sampling on the data ports of the memory with the received gating clock signal RDQS, so as to ensure synchronization of sampling to obtain a correct data signal. However, in a duty cycle adjustment process, a data signal that carries duty cycle data persists at a corresponding data port for a relatively long period of time. Therefore, the SoC may perform sampling with an internal clock signal CLKIn of the SoC without concerning a problem of sampling synchronization. In addition, in this process, the memory does not need to send the gating clock signal RDQS (or the memory sends the gating clock signal RDQS but the SoC does not use the gating clock signal RDQS), and therefore there is no need to worry about a distortion problem of the gating clock signal RDQS caused because the duty cycle adjustment is not completed.

This embodiment of the present disclosure provides a signal transmission method applied to a control apparatus. After the duty cycle start detection command/duty cycle flip detection command are delivered to the memory, the internal clock signal CLKIn is used to perform sampling on a data port of the memory to obtain a result of duty cycle detection. Therefore, sampling can be performed without a need to use a gate clock signal RDQS provided by the memory, so as to avoid a problem that a detection result cannot be sampled by the control apparatus due to distortion of the gate clock signal RDQS, thereby ensuring correctness of the duty cycle detection, further reducing a quantity of commands, and simplifying an interaction procedure.

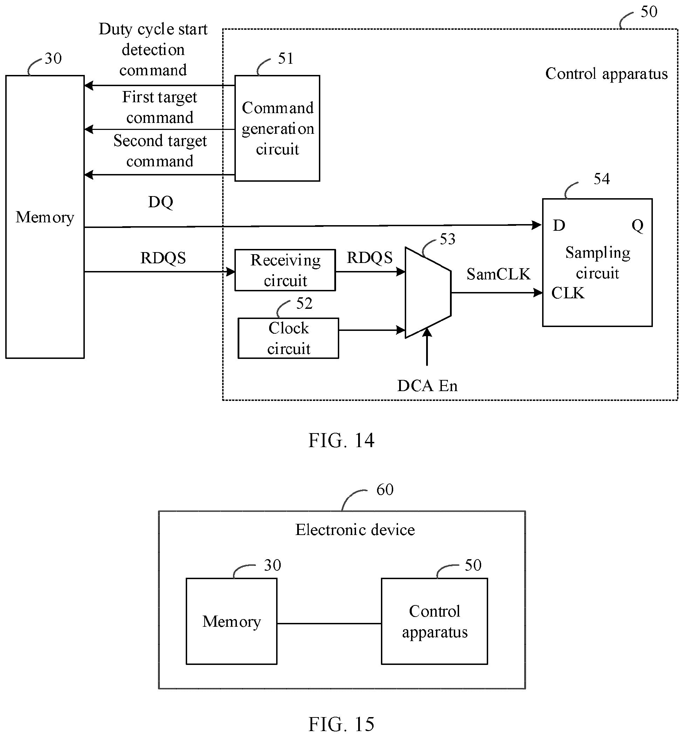

In still another embodiment of the present disclosure, to implement the foregoing signal transmission method, refer to FIG. 14. FIG. 14 shows a schematic diagram of a structure of a control apparatus 50 according to an embodiment of the present disclosure. The control apparatus 50 is connected to a memory 30. As shown in FIG. 14, the control apparatus 50 includes the following circuits.

A command generation circuit 51 is configured to: generate a first target command in a duty cycle adjustment mode, and send the first target command to the memory 30.

A clock circuit 52 is configured to generate an internal clock signal CLKIn.

A selection circuit 53 is connected to the clock circuit 52 and the memory 30, and is configured to: receive a duty cycle detection enable signal DCA En, the internal clock signal CLKIn, and a gating clock signal RDQS sent by the memory 30; and output the internal clock signal CLKIn as a sample clock signal SamCLK when the duty cycle detection enable signal DCA En represents that the control apparatus 50 is in the duty cycle adjustment mode.

A sampling circuit 54 is connected to the selection circuit 53 and a data port of the memory 30, and is configured to perform signal sampling on a first group of data ports (signals on which are collectively denoted as DQ in FIG. 14) with the sample clock signal SamCLK after the first target command is sent, to obtain first duty cycle data.

It should be noted that the clock circuit 52 may be implemented with various types of oscillators, the selection circuit 53 may be implemented with an either-or data selector, the sampling circuit 54 may be implemented with a D-type trigger, and the command generation circuit 51 may be implemented with multiple logic devices.

It should be further noted that the first duty cycle data indicates a duty cycle of an internal data clock signal in the memory. In some embodiments, the clock circuit 52 is further configured to generate an external data clock signal WCK0. The external data clock signal WCK0 is transmitted to the memory 30 to generate an internal data clock signal WCK1.

In some embodiments, the command generation circuit 51 is further configured to: generate a duty cycle detection start command in a duty cycle adjustment mode, and send the duty cycle detection start command to the memory 30. The duty cycle detection start command instructs the memory to perform duty cycle detection on the internal data clock signal to obtain the foregoing first duty cycle data.

In some embodiments, as shown in FIG. 14, the sampling circuit 54 is further configured to perform signal sampling on the first group of data ports of the memory with a sample clock signal (which is essentially the internal clock signal CLKIn) after fifth preset duration starting from sending the first target command, to obtain the first duty cycle data.

In some embodiments, the command generation circuit 51 is further configured to: generate a second target command after sending the first target command, and send the second target command to the memory.

The sampling circuit 54 is further configured to: perform signal sampling on a second group of data ports of the memory with a sample clock signal (which is essentially the internal clock signal CLKIn) after sixth preset duration starting from sending the second target command, to obtain the second duty cycle data.

For example, the first target command is a duty cycle flip detection command; and the second target command is a duty cycle flip detection output command.

In some embodiments, the command generation circuit 51 is further configured to: generate a first stop command, and send the first stop command to the memory 30; and generate a second stop command, and send the second stop command to the memory 30.

For example, the first stop command and the second stop command may be a same duty cycle stop detection command.

In some embodiments, the selection circuit 53 is further configured to output the gating clock signal RDQS as the sample clock signal SamCLK when the duty cycle detection enable signal DCAEn represents that the control apparatus 50 is not in the duty cycle adjustment mode.

In this way, in the non-duty cycle adjustment mode, the sampling circuit 54 actually performs signal sampling on a data port of the memory with the gating clock signal RDQS. However, in the duty cycle adjustment mode, the sampling circuit 54 actually performs signal sampling on the data ports of the memory with the internal clock signal CLKIn, so as to avoid a problem of a sampling error caused by distortion of the gating clock signal RDQS.

In still another embodiment of the present disclosure, refer to FIG. 15. FIG. 15 shows a schematic diagram of a composition structure of an electronic device 60 according to an embodiment of the present disclosure. As shown in FIG. 15, the electronic device 60 includes at least the foregoing memory 30 and the foregoing control apparatus 50.

The foregoing is merely preferred embodiments of the present disclosure, and is not intended to limit the protection scope of the present disclosure. It should be noted that in the present disclosure, the terms "include", "comprise", or any other variant thereof are intended to cover non-exclusive inclusion, so that a process, method, article, or apparatus that includes a series of elements includes not only those elements but also other elements that are not expressly listed, or further includes elements inherent to such a process, method, article, or apparatus. An element preceded by "includes a ..." does not, without more constraints, preclude the presence of additional identical elements in the process, method, article, or apparatus that includes the element. The sequence numbers of the foregoing embodiments of the present disclosure are merely for the purpose of description, and do not represent priorities of the embodiments. The methods disclosed in the several method embodiments provided in the present disclosure may be randomly combined when there is no conflict, to obtain new method embodiments. The features disclosed in the several product embodiments provided in the present disclosure may be randomly combined when there is no conflict, to obtain new product embodiments. The features disclosed in the several method or device embodiments provided in the present disclosure may be randomly combined when there is no conflict, to obtain new method embodiments or new device embodiments. The foregoing is merely specific implementations of the present disclosure, but is not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. An information transmission method, applied to a memory (30), and comprising:
receiving a first target command sent from the outside; and
outputting first duty cycle data of an internal data clock signal through a first group of data ports based on the first target command, wherein the first duty cycle data persists at the first group of data ports at least until a first stop command sent from the outside is received.

2. The information transmission method according to claim 1, wherein before the receiving a first target command sent from the outside, the method further comprises:
receiving a duty cycle start detection command sent from the outside; and
performing one duty cycle detection on the internal data clock signal based on the duty cycle start detection command, to generate the first duty cycle data.

3. The information transmission method according to claim 1 or 2, wherein the method further comprises:
controlling the first group of data ports to be initially in a high-impedance state;
receiving the first target command sent from the outside, and outputting the first duty cycle data through the first group of data ports after first preset duration starting from receiving the first target command, wherein the first duty cycle data persists at the first group of data ports; and
controlling the first group of data ports to restore to the high-impedance state after second preset duration starting from receiving the first stop command.

4. The information transmission method according to any one of claims 1 to 3, wherein the method further comprises:
performing another duty cycle detection on the internal data clock signal based on the first target command to generate second duty cycle data; and
receiving a second target command sent from the outside, and outputting the second duty cycle data through a second group of data ports based on the second target command, wherein the second duty cycle data persists at the second group of data ports at least until a second stop command sent from the outside is received.

5. The information transmission method according to claim 4, wherein the method further comprises:
controlling the second group of data ports to be initially in a high-impedance state;
receiving the second target command sent from the outside, and outputting the second duty cycle data through the second group of data ports after third preset duration starting from receiving the second target command, wherein the second duty cycle data persists at the second group of data ports, and the second target command is later than the first target command; and
controlling the second group of data ports to restore to the high-impedance state after fourth preset duration starting from receiving the second stop command.

6. The information transmission method according to claim 4 or 5, wherein
the first target command is a duty cycle flip detection command; the second target command is a duty cycle flip detection output command; and the first stop command and the second stop command are a same duty cycle detection stop command.

7. An information transmission method, applied to a control apparatus connected to a memory, and comprising:
sending a first target command to the memory in a duty cycle adjustment mode;
performing signal sampling on a first group of data ports of the memory with an internal clock signal after sending the first target command, to obtain first duty cycle data, wherein the internal clock signal refers to a clock signal generated inside the control apparatus; and
sending a first stop command to the memory.

8. The information transmission method according to claim 7, before the sending a first target command to the memory, further comprising:
sending a duty cycle start detection command to the memory;
wherein the duty cycle start detection command instructs the memory to perform one duty cycle detection on an internal data clock signal to generate the first duty cycle data.

9. The information transmission method according to claim 7 or 8, wherein the performing signal sampling on a first group of data ports of the memory with an internal clock signal to obtain first duty cycle data comprises:
sending the first target command to the memory, and performing signal sampling on the first group of data ports of the memory with the internal clock signal after fifth preset duration starting from sending the first target command, to obtain the first duty cycle data.

10. The information transmission method according to claim 8, wherein the first target command further instructs the memory to perform another duty cycle detection on the internal data clock signal to generate second duty cycle data; and
after the sending a first target command to the memory, the method further comprises:
sending a second target command to the memory;
performing signal sampling on a second group of data ports of the memory with the internal clock signal after sending the second target command, to obtain the second duty cycle data; and
sending a second stop command to the memory.

11. The information transmission method according to claim 10, wherein the performing signal sampling on a second group of data ports of the memory with the internal clock signal to obtain the second duty cycle data comprises:
sending the second target command to the memory, and performing signal sampling on the second group of data ports of the memory with the internal clock signal after sixth preset duration starting from sending the second target command, to obtain the second duty cycle data.

12. The information transmission method according to claim 11, wherein the first target command is a duty cycle flip detection command; the second target command is a duty cycle flip detection output command; and the first stop command and the second stop command are a same duty cycle detection stop command.

13. The information transmission method according to any one of claims 7 to 12, further comprising:
receiving a gating clock signal sent by the memory in a non-duty cycle adjustment mode; and
performing signal sampling on a data port of the memory based on the gating clock signal.

14. A memory (30), comprising:
a duty cycle detection circuit (31), configured to perform one duty cycle detection on an internal data clock signal to generate first duty cycle data; and
a transmission circuit (32), connected to both the duty cycle detection circuit and a first group of data ports (331) of the memory and configured to: receive a first target command sent from the outside, receive the first duty cycle data based on the first target command, and transmit the first duty cycle data to the first group of data ports;
wherein the first duty cycle data persists at the first group of data ports at least until the memory receives a first stop command sent from the outside.

15. The memory according to claim 14, wherein
the duty cycle detection circuit is specifically configured to: receive a duty cycle start detection command sent from the outside; and perform one duty cycle detection on the internal data clock signal based on the duty cycle start detection command, to generate the first duty cycle data;
the first group of data ports are initially in a high-impedance state; and
the transmission circuit is specifically configured to: receive the first target command sent from the outside, and transmit the first duty cycle data to the first group of data ports after first preset duration starting from receiving the first target command, wherein the first duty cycle data persists at the first group of data ports; and receive the first stop command sent from the outside, and control the first group of data ports to restore to the high-impedance state after second preset duration starting from receiving the first stop command.

16. The memory according to claim 14 or 15, wherein
the duty cycle detection circuit is further configured to: receive the first target command, and perform another duty cycle detection on the internal data clock signal based on the first target command to generate second duty cycle data;
the transmission circuit is further configured to: receive a second target command sent from the outside, receive the second duty cycle data based on the second target command, and transmit the second duty cycle data to a second group of data ports (332); and
the second duty cycle data persists at the second group of data ports at least until the memory receives a second stop command sent from the outside.

17. The memory according to claim 16, wherein the second group of data ports are initially in a high-impedance state;
the transmission circuit is specifically configured to: receive the second target command sent from the outside, and transmit the second duty cycle data to the second group of data ports after third preset duration starting from receiving the second target command, wherein the second duty cycle data persists at the second group of data ports, and the second target command is later than the first target command;
and
receive the second stop command sent from the outside, and control the second group of data ports to restore to the high-impedance state after fourth preset duration starting from receiving the second stop command.

18. The memory according to claim 17, wherein the duty cycle detection circuit (31) comprises a control circuit (311) and a detection circuit (312); and
the detection circuit is configured to perform duty cycle detection on a clock signal at a first input terminal of the detection circuit and a clock signal at a second input terminal of the detection circuit; and the control circuit is configured to: receive the internal data clock signal and a complementary signal thereof; and output the internal data clock signal to the first input terminal of the detection circuit and output the complementary signal of the internal data clock signal to the second input terminal of the detection circuit based on the received duty cycle start detection command, to enable the detection circuit to output the first duty cycle data; or
output the internal data clock signal to the second input terminal of the detection circuit and output the complementary signal of the internal data clock signal to the first input terminal of the detection circuit based on the received first target command, to enable the detection circuit to output the second duty cycle data.

19. The memory according to claim 17 or 18, wherein the first target command is a duty cycle flip detection command; the second target command is a duty cycle flip detection output command; and the first stop command and the second stop command are a same duty cycle detection stop command.

20. A control apparatus (50), connected to a memory and comprising:
a command generation circuit (51), configured to: generate a first target command in a duty cycle adjustment mode, and send the first target command to the memory;
a clock circuit (52), configured to generate an internal clock signal;
a selection circuit (53), connected to the clock circuit and the memory and configured to: receive a duty cycle detection enable signal, the internal clock signal, and a gating clock signal sent by the memory, and output the internal clock signal as a sample clock signal when the duty cycle detection enable signal represents that the control apparatus is in the duty cycle adjustment mode; and
a sampling circuit (54), connected to the selection circuit and data ports of the memory and configured to perform signal sampling on a first group of data ports with the sample clock signal after the first target command is sent, to obtain first duty cycle data.

21. The control apparatus according to claim 20, wherein
the sampling circuit is specifically configured to perform signal sampling on the first group of data ports of the memory with the sample clock signal after fifth preset duration starting from sending the first target command, to obtain the first duty cycle data.

22. The control apparatus according to claim 20 or 21, wherein
the command generation circuit is further configured to: generate a second target command after sending the first target command, and send the second target command to the memory; and
the sampling circuit is further configured to perform signal sampling on a second group of data ports of the memory with the internal clock signal after sixth preset duration starting from sending the second target command, to obtain second duty cycle data.

23. The control apparatus according to claim 22, wherein the first target command is a duty cycle flip detection command, and the second target command is a duty cycle flip detection output command.

24. The control apparatus according to any one of claims 20 to 23, wherein
the selection circuit is further configured to output the gating clock signal as a sample clock signal when the duty cycle detection enable signal represents that the control apparatus is not in the duty cycle adjustment mode.

25. An electronic device (60), comprising the memory according to any one of claims 14 to 19 and the control apparatus according to any one of claims 20 to 24.
